# EUROPEAN PATENT APPLICATION

(11) **EP 4 249 629 A1**
(43) Date of publication of application: **27.09.2023**
(21) Application number: 21894643.2
(22) Date of filing: 16.11.2021
(51) Int. Cl.: C23C 16/18, C23C 16/40, C23C 16/455, H01L 21/31, H01L 21/312, H01L 21/316

(54) **METHOD FOR MANUFACTURING THIN FILM**

(30) Priority: 19.11.2020 JP 2020192299; 12.02.2021 JP 2021020347
(71) Applicant: ADEKA CORPORATION, Arakawa-ku Tokyo 116-8554 (JP)
(72) Inventor: NISHIDA, Akihiro, Tokyo 116-8554 (JP); HATASE, Masako, Tokyo 116-8554 (JP); YOSHINO, Tomoharu, Tokyo 116-8554 (JP); OOE, Yoshiki, Tokyo 116-8554 (JP); MITSUI, Chiaki, Tokyo 116-8554 (JP)
(74) Representative: Müller-Boré & Partner Patentanwälte PartG mbB
(86) International application number: PCT/JP2021/042094
(87) International publication number: WO 2022/107769

(57) **Abstract**

Provided is a method of producing a thin-film containing a hafnium atom on a surface of a substrate by an atomic layer deposition method, including: a step 1 of causing a raw material gas obtained by vaporizing a thin-film forming raw material containing a hafnium compound represented by the following general formula (1) to adsorb to the surface of the substrate to form a precursor thin-film; a step 2 of evacuating the raw material gas remaining unreacted; and a step 3 of causing the precursor thin-film to react with a reactive gas at a temperature of 300°C or more and less than 450°C to form the thin-film containing a hafnium atom on the surface of the substrate: 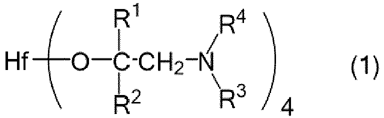 wherein R¹ and R² each independently represent a hydrogen atom or an alkyl group having 1 to 3 carbon atoms, and R³ and R⁴ each independently represent an alkyl group having 1 to 3 carbon atoms.

## Description

### Technical Field

The present invention relates to a method of producing a thin-film by an atomic layer deposition method (ALD method) through use of a hafnium compound having a specific amino alkoxide as a ligand.

### Background Art

In a semiconductor production process, a high dielectric constant material (High-k) has been required in order to meet performance demands for a high capacitance, a low leakage current, and low power consumption. Hafnium oxide (HfO₂) is known as a high dielectric constant material, and has excellent properties, such as a wide bandgap, a high refractive index, ferroelectric characteristics, and satisfactory thermal stability. Accordingly, HfO₂ is used for forming, for example, a capacitor dielectric in a dynamic random access memory (DRAM) element, a gate insulating layer in a metal oxide semiconductor field effect transistor (MOSFET), or a tunnel gate dielectric in a flash memory circuit.

A thin-film of HfO₂ is used in the above-mentioned semiconductor applications. As a method of producing the thin-film of HfO₂, there are given, for example: a sputtering method; an ion plating method; a MOD method, such as a coating thermal decomposition method or a sol-gel method; and a CVD method. Of those, an atomic layer deposition method (sometimes referred to as "ALD method") is an optimum production process because the method has, for example, the following many advantages: the method is excellent in composition controllability and step coverage; the method is suitable for mass production; and the method enables hybrid integration.

There have been reported various materials that may be used in vapor phase thin-film formation methods, such as the CVD method and the ALD method. However, a thin-film forming raw material applicable to the ALD method needs to have a temperature region called an ALD window, and the temperature region needs to be sufficiently wide. Accordingly, it is common general technical knowledge in the art that even a thin-film forming raw material that may be used in the CVD method is not suitable for the ALD method in many cases.

In Patent Document 1, there is a disclosure that a thin-film of hafnium oxide is formed at 285°C by an ALD method through use of tetraethylmethylamino hafnium (TEMAH) as a first precursor and O₂ as a second precursor.

In Patent Document 2, there is a disclosure that a thin-film containing hafnium is formed by a CVD method through use of an alkoxide compound having an amino alcohol as a ligand, as a thin-film forming raw material.

In Patent Document 3, there is a disclosure that the surface of a metal member is coated with a corrosion resistant film obtained by alternately laminating a TiO₂ film and a HfO₂ film. Further, in Patent Document 3, there is a disclosure that the HfO₂ film is formed by repeating a step of alternately introducing HfCl₄ and H₂O into a reaction container by an ALD method.

### Citation List

### Patent Document

Patent Document 1: JP 2018-100446 A
Patent Document 2: JP 4889481 B2
Patent Document 3: JP 6729437 B2

### Summary of Invention

### Technical Problem

The ALD method is a method of stacking atomic layers one by one on a substrate set in a vacuum container by repetitively performing: a step of causing a molecule of a raw material compound to adsorb to the surface of the substrate; a film forming step based on a reaction between the molecule having adsorbed to the surface of the substrate and a reactive gas; and a step of removing the redundant molecule through purging. Thus, the ALD method enables uniform film control at an atomic layer level, and hence enables the formation of a film having high homogeneity and high step coverage. However, the ALD method has difficulty in performing film formation at high temperature as compared to the CVD method, and has a problem in that carbon is liable to remain in the film.

The hafnium compound (TEMAH) disclosed in Patent Document 1 cannot be said to have sufficient thermal stability, and hence there has been a problem in that when the thin-film is produced at a temperature of more than 300°C by the ALD method, a large amount of carbon remains in the film.

In Patent Document 2, there is no description of a specific example in which the alkoxide compound having an amino alcohol as a ligand is applied to the ALD method, and there are no descriptions of production conditions in the case of using the ALD method.

HfCl₄ disclosed in Patent Document 3 is excellent in heat resistance, and hence it is described that the thin-film of hafnium oxide can be produced at a film formation temperature of from about 300°C to about 500°C through use of HfCl₄ as a thin-film forming raw material. However, there has been a problem in that chlorine remains in the film. In addition, there is a risk in that HfCl₄ may be decomposed to generate a chlorine-based corrosive compound (e.g., HCl or Cl₂). Further, there has been a problem in that HfCl₄ is difficult to vaporize and is a solid at normal temperature, and hence its handleability at the time of film formation is poor.

Accordingly, an object of the present invention is to provide a method of producing a thin-film containing a hafnium atom (hereinafter referred to as "hafnium-containing thin-film"), which is a high-quality thin-film reduced in residual carbon and residual chlorine, by an ALD method.

### Solution to Problem

The inventors of the present invention have made extensive investigations and found that the above-mentioned problems can be solved by producing a hafnium-containing thin-film by an ALD method under the specific conditions through use of a thin-film forming raw material containing a hafnium compound having a specific structure, to complete the present invention.

That is, according to one embodiment of the present invention, there is provided a method of producing a thin-film containing a hafnium atom on a surface of a substrate by an atomic layer deposition method, including: a step 1 of causing a raw material gas obtained by vaporizing a thin-film forming raw material containing a hafnium compound represented by the following general formula (1) to adsorb to the surface of the substrate to form a precursor thin-film; a step 2 of evacuating the raw material gas remaining unreacted; and a step 3 of causing the precursor thin-film to react with a reactive gas at a temperature of 300°C or more and less than 450°C to form the thin-film containing a hafnium atom on the surface of the substrate.

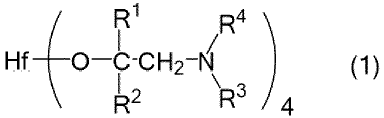

In the formula, R¹ and R² each independently represent a hydrogen atom or an alkyl group having 1 to 3 carbon atoms, and R³ and R⁴ each independently represent an alkyl group having 1 to 3 carbon atoms.

In the method of producing a thin-film according to the one embodiment of the present invention, it is preferred that the hafnium compound be a hafnium compound in which R¹ represents an ethyl group, R² represents a hydrogen atom, and R³ and R⁴ each represent a methyl group.

In the method of producing a thin-film according to the one embodiment of the present invention, it is preferred that the step 1 be performed under a state in which the substrate is heated to 300°C or more and less than 450°C.

In the method of producing a thin-film according to the one embodiment of the present invention, it is preferred that the reactive gas be an oxidizing gas, and the thin-film containing a hafnium atom be hafnium oxide.

In the method of producing a thin-film according to the one embodiment of the present invention, it is preferred that the reactive gas be a gas containing at least one selected from the group consisting of: water vapor; oxygen; and ozone.

### Advantageous Effects of Invention

According to the present invention, the hafnium-containing thin-film, which is a high-quality thin-film reduced in residual carbon and residual chlorine, can be produced.

### Brief Description of Drawings

FIG. 1 is a schematic diagram for illustrating an example of an ALD apparatus to be used in a method of producing a thin-film of the present invention.
FIG. 2 is a schematic diagram for illustrating another example of the ALD apparatus to be used in the method of producing a thin-film of the present invention.
FIG. 3 is a schematic diagram for illustrating still another example of the ALD apparatus to be used in the method of producing a thin-film of the present invention.
FIG. 4 is a schematic diagram for illustrating yet still another example of the ALD apparatus to be used in the method of producing a thin-film of the present invention.

### Description of Embodiments

A method of producing a thin-film of the present invention is described. The method of producing a thin-film of the present invention is a method including: a step 1 of causing a raw material gas obtained by vaporizing a thin-film forming raw material containing a hafnium compound represented by the general formula (1) to adsorb to a surface of a substrate to form a precursor thin-film; a step 2 of evacuating the raw material gas remaining unreacted; and a step 3 of causing the precursor thin-film to react with a reactive gas at a temperature of 300°C or more and less than 450°C to form a hafnium-containing thin-film on the surface of the substrate.

In the general formula (1), R¹ and R² each independently represent a hydrogen atom or an alkyl group having 1 to 3 carbon atoms, and R³ and R⁴ each independently represent an alkyl group having 1 to 3 carbon atoms.

The hafnium compound represented by the general formula (1), which is used as a precursor for forming a thin-film by an ALD method, preferably has a melting point of 100°C or less, and is more preferably a liquid at normal temperature because easy handleability is achieved. In addition, the thermal decomposition starting temperature of the hafnium compound obtained with a differential scanning calorimeter (DSC) is preferably 300°C or more, and from the viewpoint that excellent heat resistance is achieved, the temperature is more preferably 350°C or more.

Examples of the alkyl group having 1 to 3 carbon atoms represented by each of R¹, R², R³, and R⁴ in the general formula (1) include a methyl group, an ethyl group, a n-propyl group, and an isopropyl group. From the viewpoint that the effects of the present invention become remarkable, such a hafnium compound that, in the general formula (1), R¹ represents a hydrogen atom, a methyl group, or an ethyl group, R² represents a hydrogen atom, a methyl group, or an ethyl group, R³ represents a methyl group or an ethyl group, and R⁴ represents a methyl group or an ethyl group is preferred. In particular, such a hafnium compound that, in the general formula (1), R¹, R³, and R⁴ each represent a methyl group, and R² represents a hydrogen atom is more preferred because the hafnium compound is excellent in heat resistance. In addition, such a hafnium compound that, in the general formula (1), R¹ represents an ethyl group, R² represents a hydrogen atom, and R³ and R⁴ each represent a methyl group is still more preferred because the hafnium compound has a low viscosity at normal temperature, and hence a thin-film forming raw material containing the hafnium compound can be improved in transportability, with the result that a thin-film obtained through use of the thin-film forming raw material can be increased in productivity.

Preferred specific examples of the hafnium compound represented by the general formula (1) include Hafnium Compounds No. 1 to No. 18 below. However, the present invention is not limited to those hafnium compounds. In Hafnium Compounds No. 1 to No. 18 below, "Me" represents a methyl group, and "Et" represents an ethyl group.

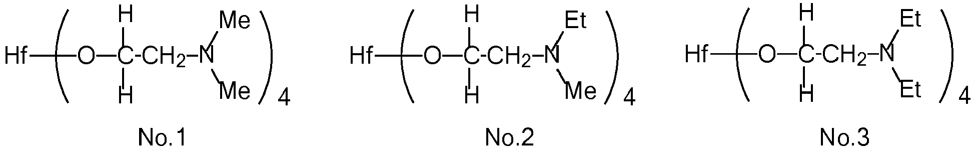

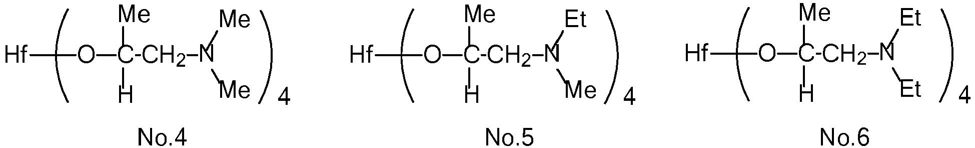

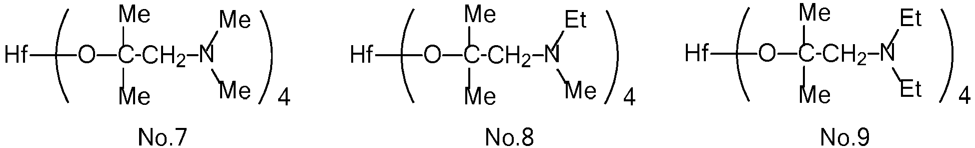

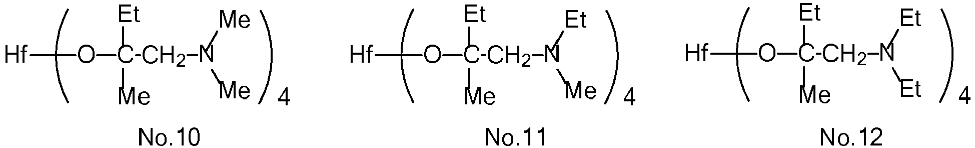

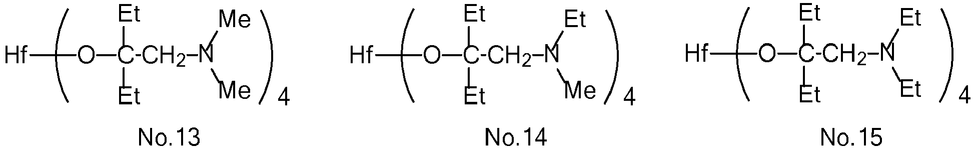

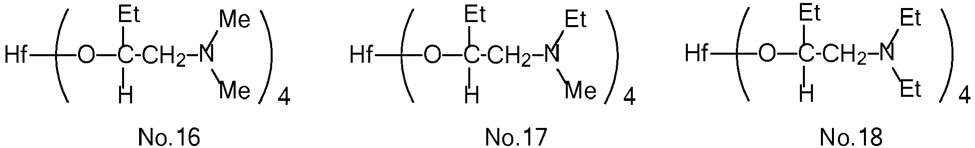

The hafnium compound represented by the general formula (1) may be produced by utilizing a well-known reaction. For example, such a hafnium compound that, in the general formula (1), R¹, R³, and R⁴ each represent a methyl group, and R² represents a hydrogen atom may be obtained by causing tetrakis(ethylmethylamido)hafnium and 1-dimethylamino-2-propanol to react with each other. In addition, such a hafnium compound that, in the general formula (1), R¹ represents an ethyl group, R² represents a hydrogen atom, and R³ and R⁴ each represent a methyl group may be obtained by causing tetrakis(ethylmethylamido)hafnium and 1-dimethylamino-2-butanol to react with each other.

The thin-film forming raw material to be used in the method of producing a thin-film of the present invention only needs to contain the hafnium compound represented by the general formula (1) as a precursor of a thin-film, and the composition thereof varies depending on the composition of a thin-film to be targeted. For example, when a thin-film containing only hafnium as a metal is produced, the thin-film forming raw material is free of a metal compound other than hafnium and a semimetal compound. Meanwhile, when a thin-film containing hafnium and another metal and/or a semimetal is produced, the thin-film forming raw material may include a compound containing the desired metal and/or a compound containing the desired semimetal (hereinafter referred to as "other precursor") in addition to the hafnium compound represented by the general formula (1).

In the case of a multi-component ALD method in which a plurality of precursors are used, there is no particular limitation on the other precursor that may be used together with the hafnium compound represented by the general formula (1), and a well-known general precursor used for the thin-film forming raw material for an ALD method may be used.

Examples of the above-mentioned other precursor include compounds each formed of: one or two or more selected from the group consisting of compounds used as organic ligands, such as an alcohol compound, a glycol compound, a β-diketone compound, a cyclopentadiene compound, and an organic amine compound; and boron or a metal. In addition, examples of the kind of the metal in the precursor include lithium, sodium, potassium, magnesium, calcium, strontium, barium, titanium, zirconium, hafnium, vanadium, niobium, tantalum, chromium, molybdenum, tungsten, manganese, iron, osmium, ruthenium, cobalt, rhodium, iridium, nickel, palladium, platinum, copper, silver, gold, zinc, aluminum, gallium, indium, germanium, lead, antimony, bismuth, radium, scandium, ruthenium, yttrium, lanthanum, cerium, praseodymium, neodymium, promethium, samarium, europium, gadolinium, terbium, dysprosium, holmium, erbium, thulium, ytterbium, and lutetium.

Examples of the alcohol compound to be used as the organic ligand in the above-mentioned other precursor include: alkyl alcohols, such as methanol, ethanol, propanol, isopropyl alcohol, butanol, sec-butyl alcohol, isobutyl alcohol, tert-butyl alcohol, pentyl alcohol, isopentyl alcohol, and tertpentyl alcohol; ether alcohols, such as 2-methoxyethanol, 2-ethoxyethanol, 2-butoxyethanol, 2-(2-methoxyethoxy)ethanol, 2-methoxy-1-methylethanol, 2-methoxy-1,1-dimethylethanol, 2-ethoxy-1,1-dimethylethanol, 2-isopropoxy-1,1-dimethylethanol, 2-butoxy-1,1-dimethylethanol, 2-(2-methoxyethoxy)-1,1-dimethylethanol, 2-propoxy-1,1-diethylethanol, 2-sec-butoxy-1,1-diethylethanol, and 3-methoxy-1,1-dimethylpropanol; and dialkylamino alcohols, such as dimethylaminoethanol, ethylmethylaminoethanol, diethylaminoethanol, dimethylamino-2-pentanol, ethylmethylamino-2-pentanol, dimethylamino-2-methyl-2-pentanol, ethylmethylamino-2-methyl-2-pentanol, and diethylamino-2-methyl-2-pentanol.

Examples of the glycol compound to be used as the organic ligand in the above-mentioned other precursor include 1,2-ethanediol, 1,2-propanediol, 1,3-propanediol, 2,4-hexanediol, 2,2-dimethyl-1,3-propanediol, 2,2-diethyl-1,3-propanediol, 1,3-butanediol, 2,4-butanediol, 2,2-diethyl-1,3-butanediol, 2-ethyl-2-butyl-1,3-propanediol, 2,4-pentanediol, 2-methyl-1,3-propanediol, 2-methyl-2,4-pentanediol, 2,4-hexanediol, and 2,4-dimethyl-2,4-pentanediol.

Examples of the β-diketone compound to be used as the organic ligand in the above-mentioned other precursor include: alkyl-substituted β-diketones, such as acetylacetone, hexane-2,4-dione, 5-methylhexane-2,4-dione, heptane-2,4-dione, 2-methylheptane-3,5-dione, 5-methylheptane-2,4-dione, 6-methylheptane-2,4-dione, 2,2-dimethylheptane-3,5-dione, 2,6-dimethylheptane-3,5-dione, 2,2,6-trimethylheptane-3,5-dione, 2,2,6,6-tetramethylheptane-3,5-dione, octane-2,4-dione, 2,2,6-trimethyloctane-3,5-dione, 2,6-dimethyloctane-3,5-dione, 2,9-dimethylnonane-4,6-dione, 2-methyl-6-ethyldecane-3,5-dione, and 2,2-dimethyl-6-ethyldecane-3,5-dione; fluorine-substituted alkyl β-diketones, such as 1,1,1-trifluoropentane-2,4-dione, 1,1,1-trifluoro-5,5-dimethylhexane-2,4-dione, 1,1,1,5,5,5-hexafluoropentane-2,4-dione, and 1,3-diperfluorohexylpropane-1,3-dione; and ether-substituted β-diketones, such as 1,1,5,5-tetramethyl-1-methoxyhexane-2,4-dione, 2,2,6,6-tetramethyl-1-methoxyheptane-3,5-dione, and 2,2,6,6-tetramethyl-1-(2-methoxyethoxy)heptane-3,5-dione.

Examples of the cyclopentadiene compound to be used as the organic ligand in the above-mentioned other precursor include cyclopentadiene, methylcyclopentadiene, ethylcyclopentadiene, propylcyclopentadiene, isopropylcyclopentadiene, butylcyclopentadiene, secbutylcyclopentadiene, isobutylcyclopentadiene, tertbutylcyclopentadiene, dimethylcyclopentadiene, tetramethylcyclopentadiene, and pentamethylcyclopentadiene.

Examples of the organic amine compound to be used as the organic ligand in the above-mentioned other precursor include methylamine, ethylamine, propylamine, isopropylamine, butylamine, sec-butylamine, tert-butylamine, isobutylamine, dimethylamine, diethylamine, dipropylamine, diisopropylamine, ethylmethylamine, propylmethylamine, and isopropylmethylamine.

The above-mentioned other precursors are known in the art, and production methods therefor are also known. An example of the production methods is given as described below. For example, when the alcohol compound is used as the organic ligand, the precursor may be produced through a reaction between an inorganic salt of the metal described above or a hydrate thereof and an alkali metal alkoxide of the alcohol compound. In this case, examples of the inorganic salt of the metal or the hydrate thereof may include a halide and a nitrate of the metal. Examples of the alkali metal alkoxide may include a sodium alkoxide, a lithium alkoxide, and a potassium alkoxide.

Examples of such a multi-component ALD method as described above include: a method involving vaporizing and supplying each component of the thin-film forming raw material independently (hereinafter sometimes referred to as "single source method"); and a method involving vaporizing and supplying a mixed raw material obtained by mixing multi-component raw materials in accordance with desired composition in advance (hereinafter sometimes referred to as "cocktail source method"). In the case of the single source method, the above-mentioned other precursor is preferably a compound similar to the hafnium compound represented by the general formula (1) in the behavior of thermal decomposition and/or oxidative decomposition. In the case of the cocktail source method, the above-mentioned other precursor is preferably a compound that not only is similar to the hafnium compound represented by the general formula (1) in the behavior of thermal decomposition and/or oxidative decomposition but also is prevented from being altered through a chemical reaction or the like at the time of mixing.

In the case of the cocktail source method in the multi-component ALD method, a mixture of the hafnium compound represented by the general formula (1) and the other precursor, or a mixed solution obtained by dissolving the mixture in an organic solvent may be used as the thin-film forming raw material.

There is no particular limitation on the above-mentioned organic solvent, and a well-known general organic solvent may be used. Examples of the organic solvent include: acetic acid esters, such as ethyl acetate, butyl acetate, and methoxyethyl acetate; ethers, such as tetrahydrofuran, tetrahydropyran, ethylene glycol dimethyl ether, diethylene glycol dimethyl ether, triethylene glycol dimethyl ether, dibutyl ether, and dioxane; ketones, such as methyl butyl ketone, methyl isobutyl ketone, ethyl butyl ketone, dipropyl ketone, diisobutyl ketone, methyl amyl ketone, cyclohexanone, and methylcyclohexanone; hydrocarbons, such as hexane, cyclohexane, methylcyclohexane, dimethylcyclohexane, ethylcyclohexane, heptane, octane, toluene, and xylene; hydrocarbons each having a cyano group, such as 1-cyanopropane, 1-cyanobutane, 1-cyanohexane, cyanocyclohexane, cyanobenzene, 1,3-dicyanopropane, 1,4-dicyanobutane, 1,6-dicyanohexane, 1,4-dicyanocyclohexane, and 1,4-dicyanobenzene; and pyridine and lutidine. Those organic solvents may be used alone or as a mixture thereof depending on the solubility of a solute, the relationship among the use temperature, boiling point, and flash point of the solvent, and the like.

In the method of producing a thin-film of the present invention, when the thin-film forming raw material is a mixed solution including the organic solvent, the total precursor amount in the thin-film forming raw material may be controlled to from 0.01 mol/liter to 2.0 mol/liter, particularly from 0.05 mol/liter to 1.0 mol/liter.

Herein, when the thin-film forming raw material is free of the metal compound other than hafnium and the semimetal compound, the total precursor amount represents the amount of the hafnium compound represented by the general formula (1) (however, when the thin-film forming raw material contains a hafnium compound other than the hafnium compound represented by the general formula (1), the total precursor amount represents the total amount thereof). When the thin-film forming raw material contains the other precursor in addition to the hafnium compound represented by the general formula (1), the total precursor amount represents the total amount of the hafnium compound represented by the general formula (1) and the other precursor.

In addition, in the method of producing a thin-film of the present invention, the thin-film forming raw material may include a nucleophilic reagent for improving the stability of each of the hafnium compound represented by the general formula (1) and the other precursor as required. Examples of the nucleophilic reagent include: ethylene glycol ethers, such as glyme, diglyme, triglyme, and tetraglyme; crown ethers, such as 18-crown-6, dicyclohexyl-18-crown-6, 24-crown-8, dicyclohexyl-24-crown-8, and dibenzo-24-crown-8; polyamines, such as ethylenediamine, N,N'-tetramethylethylenediamine, diethylenetriamine, triethylenetetramine, tetraethylenepentamine, pentaethylenehexamine, 1,1,4,7,7-pentamethyldiethylenetriamine, 1,1,4,7,10,10-hexamethyltriethylenetetramine, and triethoxytriethyleneamine; cyclic polyamines, such as cyclam and cyclen; heterocyclic compounds, such as pyridine, pyrrolidine, piperidine, morpholine, N-methylpyrrolidine, N-methylpiperidine, N-methylmorpholine, tetrahydrofuran, tetrahydropyran, 1,4-dioxane, oxazole, thiazole, and oxathiolane; β-keto esters, such as methyl acetoacetate, ethyl acetoacetate, and 2-methoxyethyl acetoacetate; and β-diketones, such as acetylacetone, 2,4-hexanedione, 2,4-heptanedione, 3,5-heptanedione, and dipivaloylmethane. From the viewpoint that the control of the stability becomes easy, the usage amount of such nucleophilic reagent falls within the range of preferably from 0.1 mol to 10 mol, more preferably from 1 mol to 4 mol with respect to 1 mol of the total precursor amount.

It is desired that the thin-film forming raw material be prevented from including impurity metal elements other than the components for forming the raw material, impurity halogens such as impurity chlorine, and impurity organic substances to the extent possible. The content of each of the impurity metal elements is preferably 100 ppb or less, more preferably 10 ppb or less, and the total content thereof is preferably 1 ppm or less, more preferably 100 ppb or less. In particular, when the raw material is used as a gate insulating film, a gate film, or a barrier layer of an LSI, it is required to reduce the contents of alkali metal elements and alkaline-earth metal elements that influence the electrical characteristics of a thin-film to be obtained. The content of the impurity halogens is preferably 100 ppm or less, more preferably 10 ppm or less, still more preferably 1 ppm or less. The total content of the impurity organic substances is preferably 500 ppm or less, more preferably 50 ppm or less, still more preferably 10 ppm or less. In addition, moisture causes generation of particles in a raw material for ALD and generation of particles during thin-film formation. Accordingly, in order to reduce moisture in each of the precursor, the organic solvent, and the nucleophilic reagent, the moisture is desirably removed as much as possible in advance at the time of use. The moisture content of each of the precursor, the organic solvent, and the nucleophilic reagent is preferably 10 ppm or less, more preferably 1 ppm or less.

In addition, it is preferred that the thin-film forming raw material be prevented from including particles to the extent possible in order to reduce or prevent particle contamination of a thin-film to be formed. Specifically, in particle measurement with a light scattering liquid particle detector in a liquid phase, it is preferred that the number of particles larger than 0.3 um be 100 or less in 1 ml of the thin-film forming raw material, and it is more preferred that the number of particles larger than 0.2 um be 100 or less in 1 ml of the thin-film forming raw material because a uniform thin-film is easily obtained.

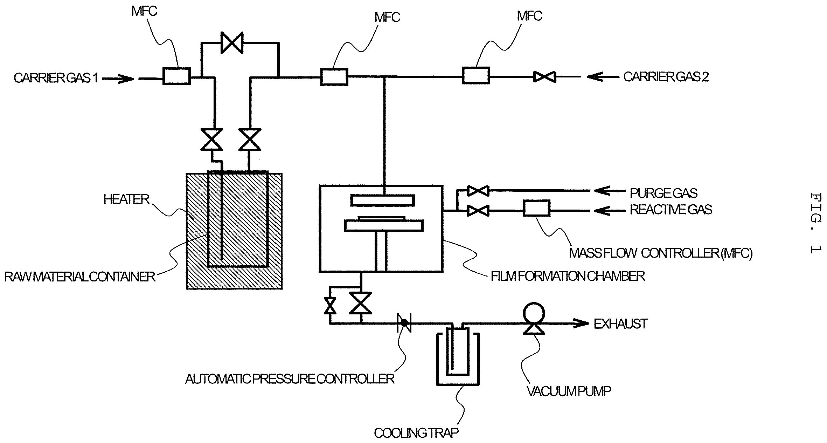

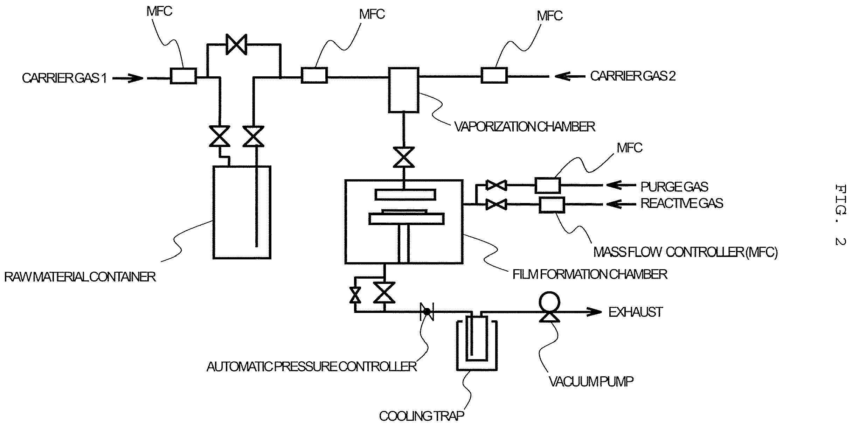

Specific examples of an ALD apparatus to be used in the method of producing a thin-film of the present invention include: such an apparatus as illustrated in FIG. 1 capable of heating and/or decompressing the thin-film forming raw material in a raw material container, to thereby vaporize the raw material to obtain a raw material gas, and supplying the raw material gas to a film formation chamber together with a carrier gas as required; and such an apparatus as illustrated in FIG. 2 capable of transporting the thin-film forming raw material under the state of a liquid or a solution to a vaporization chamber, heating and/or decompressing the raw material in the vaporization chamber, to thereby vaporize the raw material to obtain a raw material gas, and supplying the raw material gas to a film formation chamber. The apparatus is not limited to such a single-substrate type apparatus including a film formation chamber as illustrated in each of FIG. 1 and FIG. 2, and an apparatus capable of simultaneously processing a large number of substrates through use of a batch furnace may also be used.

The method of producing a thin-film of the present invention includes: a step 1 (precursor thin-film formation step) of, in a film formation chamber (hereinafter sometimes referred to as "deposition reaction portion") having a substrate set therein, causing a raw material gas obtained by vaporizing the thin-film forming raw material to adsorb to the surface of the substrate to form a precursor thin-film; a step 2 (evacuation step) of evacuating the raw material gas remaining unreacted; and a step 3 (hafnium-containing thin-film formation step) of introducing a reactive gas into the film formation chamber to cause the precursor thin-film to react with the reactive gas at a temperature of 300°C or more and less than 450°C, to thereby form a hafnium-containing thin-film on the surface of the substrate.

In addition, the method of producing a thin-film of the present invention preferably includes, after the step 3, a step 4 (evacuation step) of evacuating the gas in the film formation chamber.

In the method of producing a thin-film of the present invention, when deposition performed by a series of operations of the step 1 (precursor thin-film formation step), the step 2 (evacuation step), the step 3 (hafnium-containing thin-film formation step), and the step 4 (evacuation step) in the stated order is defined as one cycle, and the cycle is repeated a plurality of times, the thickness of the thin-film can be controlled. The steps of the method of producing a thin-film of the present invention are described below.

### (Step 1)

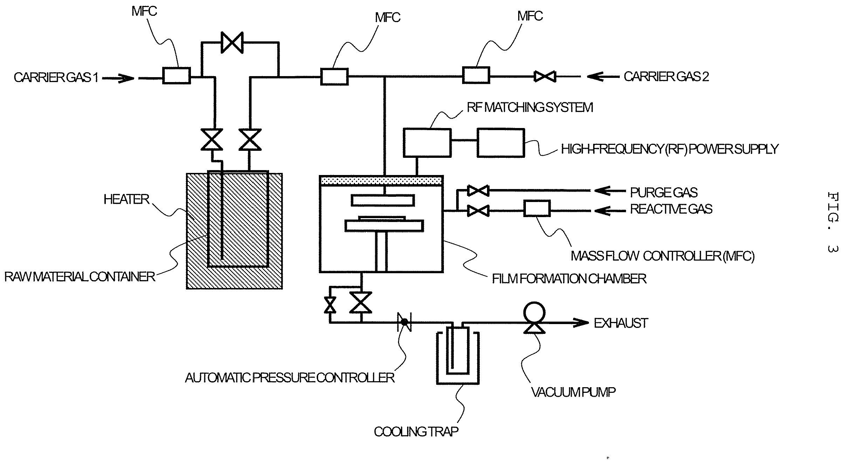

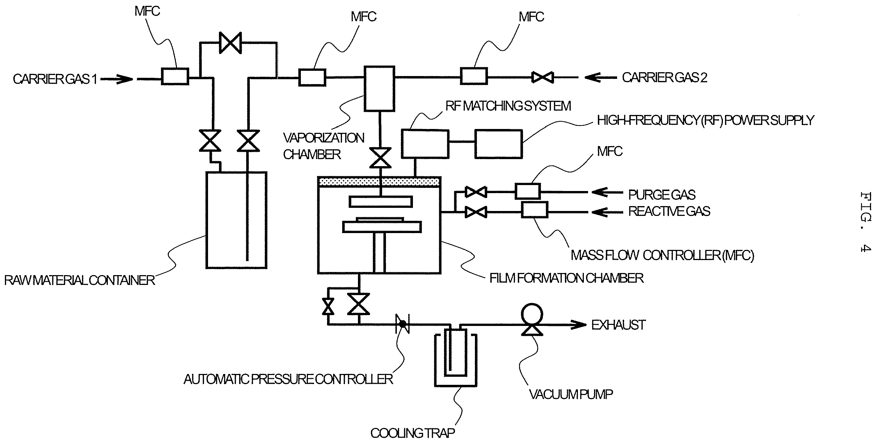

The step 1 is a step of introducing a raw material gas obtained by vaporizing the thin-film forming raw material into a film formation chamber having a substrate set therein to cause the raw material gas to adsorb to the surface of the substrate, to thereby form a precursor thin-film. As an introduction method for the raw material gas obtained by vaporizing the thin-film forming raw material into the film formation chamber having the substrate set therein, there are given: a gas transportation method involving heating and/or decompressing the thin-film forming raw material in a container in which the raw material is stored (hereinafter referred to as "raw material container"), to thereby vaporize the thin-film forming raw material to obtain a raw material gas, and introducing the raw material gas into the film formation chamber having the substrate set therein together with a carrier gas, such as argon, nitrogen, or helium, as required as illustrated in each of FIG. 1 and FIG. 3; and a liquid transportation method involving transporting the thin-film forming raw material under the state of a liquid or a solution to a vaporization chamber, heating and/or decompressing the raw material in the vaporization chamber, to thereby vaporize the thin-film forming raw material to obtain a raw material gas, and introducing the raw material gas into the film formation chamber having the substrate set therein as illustrated in each of FIG. 2 and FIG. 4. In the case of the gas transportation method, the hafnium compound represented by the general formula (1) itself may be used as the thin-film forming raw material. In the case of the liquid transportation method, the hafnium compound represented by the general formula (1) or a solution obtained by dissolving the hafnium compound in an organic solvent may be used as the thin-film forming raw material. Such thin-film forming raw material may further contain a nucleophilic reagent or the like.

In addition, as a method to be used in a raw material gas introduction step other than the gas transportation method and the liquid transportation method, there are given such a single source method and a cocktail source method as described above each serving as a multi-component ALD method including a plurality of precursors. Regardless of which introduction method is used, from the viewpoint of handleability, the thin-film forming raw material is preferably vaporized in the range of 50°C or more and 200°C or less. In addition, when the thin-film forming raw material is vaporized to provide the raw material gas in the raw material container or in the vaporization chamber, from the viewpoint that the thin-film forming raw material is easily vaporized, a pressure in the raw material container and a pressure in the vaporization chamber are each preferably 1 Pa or more and 10,000 Pa or less.

Herein, as a material for the substrate to be set in the film formation chamber, there are given, for example: silicon; ceramics, such as silicon nitride, titanium nitride, tantalum nitride, titanium oxide, ruthenium oxide, zirconium oxide, hafnium oxide, and lanthanum oxide; glass; and metals, such as metal cobalt and metal ruthenium. As a shape of the substrate, there are given, for example, a plate shape, a spherical shape, a fiber shape, and a scale-like shape. The surface of the substrate may be planar, or may have a three-dimensional structure such as a trench structure.

After the raw material gas is introduced into the film formation chamber, the precursor thin-film can be formed on the surface of the substrate by causing the raw material gas to adsorb to the surface of the substrate. At this time, the substrate may be heated, or an inside of the film formation chamber may be heated. The conditions at the time of forming the precursor thin-film are not particularly limited, and for example, an adsorption temperature (substrate temperature), a system pressure, or the like may be appropriately determined depending on the kind of the thin-film forming raw material. The step 1 is preferably performed under a state in which the substrate is heated to 300°C or more. From the viewpoint that a uniform precursor thin-film is easily obtained, the step 1 is more preferably performed under a state in which the substrate is heated to 300°C or more and less than 450°C. The system pressure is not particularly limited, but is preferably 1 Pa or more and 10,000 Pa or less. From the viewpoint that a uniform precursor thin-film is easily obtained, the system pressure is more preferably 10 Pa or more and 1,000 Pa or less.

### (Step 2)

The step 2 is a step of evacuating, after the formation of the precursor thin-film, the raw material gas remaining unreacted, the gas not having adsorbed to the surface of the substrate, from the film formation chamber. In this step, it is ideal that the raw material gas not having adsorbed be completely evacuated from the film formation chamber, but it is not always required that the gas be completely evacuated. As an evacuation method, there are given, for example, a method involving purging the system of the film formation chamber with an inert gas, such as helium, nitrogen, or argon, a method involving performing evacuation by decompressing the system, and a combination of these methods. The degree of decompression in the case of performing decompression preferably falls within the range of 0.01 Pa or more and 300 Pa or less, and from the viewpoint that the evacuation of the raw material gas not having adsorbed is promoted, the degree of decompression more preferably falls within the range of 0.01 Pa or more and 100 Pa or less.

### (Step 3)

The step 3 is a step of, after the step 2, introducing a reactive gas into the film formation chamber to cause the precursor thin-film, that is, the hafnium compound represented by the general formula (1), which has been deposited on the surface of the substrate, to react with the reactive gas through the action of the reactive gas and the action of heat, to thereby form a hafnium-containing thin-film.

Examples of the reactive gas include: oxidizing gases, such as oxygen, ozone, nitrogen dioxide, nitrogen monoxide, water vapor, hydrogen peroxide, formic acid, acetic acid, and acetic anhydride; reducing gases such as hydrogen; and nitriding gases, such as organic amine compounds including a monoalkylamine, a dialkylamine, a trialkylamine, and an alkylenediamine, hydrazine, and ammonia. Those reactive gases may be used alone or as a mixture thereof. In the method of producing a thin-film of the present invention, the reactive gas is preferably an oxidizing gas, and from the viewpoint that reactivity between the precursor thin-film and the reactive gas becomes satisfactory, the reactive gas is more preferably a gas containing at least one selected from the group consisting of: water vapor; oxygen; and ozone. When the oxidizing gas is used as the reactive gas, a hafnium oxide thin-film is formed as the hafnium-containing thin-film.

A temperature (substrate temperature) at the time of causing the precursor thin-film to react with the reactive gas is 300°C or more and less than 450°C, and from the viewpoint that a high-quality thin-film more reduced in residual carbon is obtained, the temperature is preferably 300°C or more and less than 430°C. In addition, a pressure in the film formation chamber at the time of performing this step is preferably 1 Pa or more and 10,000 Pa or less, and from the viewpoint that reactivity between the precursor thin-film and the reactive gas becomes satisfactory, the pressure is more preferably 10 Pa or more and 1,000 Pa or less.

### (Step 4)

The step 4 is a step of, after the step 3, evacuating the reactive gas remaining unreacted and a by-product gas from the film formation chamber in order to produce a high-quality thin-film. In this step, it is ideal that the reactive gas and the by-product gas be completely evacuated from the film formation chamber, but it is not always required that the gases be completely evacuated. An evacuation method and the degree of decompression in the case of performing decompression are the same as those in the above-mentioned step 2.

When a series of operations of the step 1, the step 2, the step 3, and the step 4 described above is defined as one cycle, the film thickness of the hafnium-containing thin-film to be obtained can be controlled by the number of the cycles.

In addition, in the method of producing a thin-film of the present invention, energy, such as plasma, light, or a voltage, may be applied in the film formation chamber as illustrated in each of FIG. 3 and FIG. 4, or a catalyst may be used therein. The timing at which the energy is applied and the timing at which the catalyst is used are not particularly limited. The energy may be applied or the catalyst may be used, for example, at the time of the introduction of the raw material gas into the film formation chamber or at the time of the heating in forming the precursor thin-film in the step 1, at the time of the introduction of the reactive gas into the film formation chamber or at the time of causing the reactive gas and the precursor thin-film to react with each other in the step 3, at the time of the evacuation of the system in the step 2 or 4, or between the above-mentioned respective steps.

In addition, in the method of producing a thin-film of the present invention, after the thin-film formation, annealing treatment may be performed under an inert atmosphere, under an oxidizing atmosphere, or under a reducing atmosphere in order that more satisfactory electrical characteristics may be obtained. When step embedding is required, a reflow step may be provided. A temperature in this case is preferably 200°C or more and 1,000°C or less, and from the viewpoint that damage to the thin-film or the substrate caused by heat can be suppressed, the temperature is more preferably 250°C or more and 500°C or less.

The thin-film to be produced by the method of producing a thin-film of the present invention can be provided as a desired kind of thin-film by appropriately selecting the other precursor, the reactive gas, and the production conditions, to thereby coat the substrate made of, for example, a metal, an oxide ceramic, a nitride ceramic, or glass. The thin-film of the present invention is excellent in electrical characteristics and optical characteristics, and hence can be widely used in the production of, for example, an electrode material for a memory element typified by a DRAM element, a resistance film, a diamagnetic film used in the recording layer of a hard disk, and a catalyst material for a polymer electrolyte fuel cell.

### Examples

The present invention is described in more detail below by way of Examples. However, the present invention is by no means limited by Examples and the like below.

The following test compounds were subjected to the following evaluations.
No. 4: tetrakis((1-dimethylamino)propan-2-yl)oxy)hafnium
No. 16: tetrakis((1-dimethylamino)butan-2-yl)oxy)hafnium
Comparative Compound 1: tetrakis(ethylmethylamino)hafnium (TEMAH)
Comparative Compound 2: hafnium tetrachloride (HfCl₄)

### (1) Melting Point Evaluation

The state of each of the compounds at normal pressure and 25°C was visually observed. The results are shown in Table 1.

### (2) Thermal Decomposition Starting Temperature

In a DSC chart measured with a differential scanning calorimeter (DSC) at an argon flow rate of 20 mL/min and a temperature increase rate of 10°C/min in a scanning temperature range of from 30°C to 500°C, an exothermic or endothermic starting point was evaluated as a thermal decomposition starting temperature (°C). The results are shown in Table 1.

### (3) Viscosity

The viscosity at 25°C was measured with a rolling-ball viscometer (manufactured by Anton Paar, product name: AMVn). The results are shown in Table 2.

**Table 1**

| Test compound | No. 4 | No. 16 | Comparative Compound 1 | Comparative Compound 2 |
|---|---|---|---|---|
| Melting point evaluation | viscous liquid | Liquid | Liquid | Liquid |
| Thermal decomposition starting temperature | 371°C | 346°C | 283°C | More than 400°C |

**Table 2**

| Test compound | No. 4 | No. 16 |
|---|---|---|
| Viscosity [cP] | 7,459 | 279 |

Next, a thin-film was produced through use of each of the test compounds as a thin-film forming raw material.

### [Example 1]

A thin-film was produced on a silicon wafer serving as a substrate through use of the above-mentioned Hafnium Compound No. 4 as a thin-film forming raw material with the ALD apparatus of FIG. 1 under the following conditions and through the following steps. When the composition of the thin-film was analyzed by X-ray photoelectron spectroscopy, it was recognized that the thin-film was a hafnium oxide thin-film, and a residual carbon content in the thin-film was less than 0.01 atm%, which was a detection limit. In addition, when the film thickness of the thin-film was measured by an X-ray reflectivity method, the thin-film formed on the substrate was a flat and smooth film having a film thickness of 2.5 nm, and a film thickness of about 0.025 nm was obtained per cycle.

In addition, a thin-film was produced under the same conditions except that the reaction temperature was increased from 200°C to 400°C by 50°C, and an ALD window was observed by plotting a saturated temperature-dependent growth rate per cycle. As a result, an ALD window of from 250°C to 350°C was able to be recognized.

### (Conditions)

Production method: ALD method
Reaction temperature (substrate temperature): 350°C
Reactive gas: ozone

### (Steps)

A series of steps including the following step 1 to step 4 was defined as one cycle, and this cycle was repeated 100 times.

Step 1: Vapor (raw material gas) of the thin-film forming raw material obtained by vaporization under the conditions of a raw material container temperature of 150°C and a raw material container internal pressure of 26.67 Pa is introduced into a film formation chamber, and the raw material gas is caused to adsorb to the surface of the substrate at a system pressure of 26.67 Pa for 10 seconds, to thereby form a precursor thin-film.

Step 2: The raw material gas not having adsorbed is evacuated from the system through argon purging for 15 seconds.

Step 3: The reactive gas is introduced into the film formation chamber, and the precursor thin-film is caused to react with the reactive gas at a system pressure of 100 Pa for 10 seconds.

Step 4: The reactive gas remaining unreacted and a by-product gas are evacuated from the system through argon purging for 15 seconds.

### [Example 2]

A thin-film was produced on a silicon wafer serving as a substrate under the same conditions as those in Example 1 except that the reaction temperature was changed from 350°C to 375°C. When the composition of the thin-film was analyzed by X-ray photoelectron spectroscopy, it was recognized that the thin-film was a hafnium oxide thin-film, and a residual carbon content in the thin-film was less than 0.01 atm%, which was a detection limit.

### [Example 3]

A thin-film was produced on a silicon wafer serving as a substrate under the same conditions as those in Example 1 except that the reaction temperature was changed from 350°C to 425°C. When the composition of the thin-film was analyzed by X-ray photoelectron spectroscopy, it was recognized that the thin-film was a hafnium oxide thin-film, and a residual carbon content in the thin-film was less than 0.01 atm%, which was a detection limit.

### [Comparative Example 1]

A thin-film was produced on a silicon wafer serving as a substrate under the same conditions as those in Example 1 except that the reaction temperature was changed from 350°C to 250°C. When the composition of the thin-film was analyzed by X-ray photoelectron spectroscopy, the thin-film was a hafnium oxide thin-film, and a residual carbon content in the thin-film was 4.76 atmo.

### [Comparative Example 2]

A thin-film was produced on a silicon wafer serving as a substrate under the same conditions as those in Example 1 except that the reaction temperature was changed from 350°C to 475°C. However, it was recognized that thermal decomposition occurred in the thin-film. The analysis of the composition of the thin-film by X-ray photoelectron spectroscopy was not performed.

### [Comparative Example 3]

A thin-film was produced on a silicon wafer serving as a substrate under the same conditions as those in Example 1 except that Hafnium Compound No. 4 was changed to Comparative Compound 1. When the composition of the thin-film was analyzed by X-ray photoelectron spectroscopy, the thin-film was a hafnium oxide thin-film, but residual carbon was detected therein.

In addition, a thin-film was produced by increasing the reaction temperature from 200°C to 400°C by 50°C, and an ALD window was observed by plotting a saturated temperature-dependent growth rate per cycle. As a result, an ALD window of from 200°C to 250°C was recognized.

### [Comparative Example 4]

A thin-film was produced on a silicon wafer serving as a substrate under the same conditions as those in Example 1 except that Hafnium Compound No. 4 was changed to Comparative Compound 2. When the composition of the thin-film was analyzed by X-ray photoelectron spectroscopy, the thin-film was a hafnium oxide thin-film, but residual chlorine was detected therein.

In addition, a thin-film was produced by increasing the reaction temperature from 200°C to 400°C by 50°C, and an ALD window was observed by plotting a saturated temperature-dependent growth rate per cycle. As a result, an ALD window of from 200°C to 400°C was recognized.

As described above, in the present invention, when a thin-film is produced through use of the thin-film forming raw material containing the specific hafnium compound under the specific conditions, a high-quality hafnium-containing thin-film reduced in residual carbon and residual chlorine can be produced.

## Claims

1. A method of producing a thin-film containing a hafnium atom on a surface of a substrate by an atomic layer deposition method, comprising:
a step 1 of causing a raw material gas obtained by vaporizing a thin-film forming raw material containing a hafnium compound represented by the following general formula (1) to adsorb to the surface of the substrate to form a precursor thin-film;
a step 2 of evacuating the raw material gas remaining unreacted; and
a step 3 of causing the precursor thin-film to react with a reactive gas at a temperature of 300°C or more and less than 450°C to form the thin-film containing a hafnium atom on the surface of the substrate: 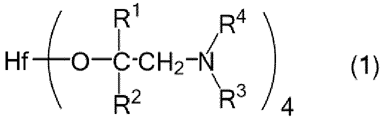 wherein R¹ and R² each independently represent a hydrogen atom or an alkyl group having 1 to 3 carbon atoms, and R³ and R⁴ each independently represent an alkyl group having 1 to 3 carbon atoms.

2. The method of producing a thin-film according to claim 1, wherein the hafnium compound is a hafnium compound in which R¹ represents an ethyl group, R² represents a hydrogen atom, and R³ and R⁴ each represent a methyl group.

3. The method of producing a thin-film according to claim 1 or 2, wherein the step 1 is performed under a state in which the substrate is heated to 300°C or more and less than 450°C.

4. The method of producing a thin-film according to any one of claims 1 to 3,
wherein the reactive gas is an oxidizing gas, and
wherein the thin-film containing a hafnium atom is hafnium oxide.

5. The method of producing a thin-film according to any one of claims 1 to 4, wherein the reactive gas is a gas containing at least one selected from the group consisting of: water vapor; oxygen; and ozone.
